# EUROPÄISCHE PATENTSCHRIFT

(11) **EP 2 917 795 B1**
(45) Veröffentlichungstag und Bekanntmachung des Hinweises auf die Patenterteilung: **23.08.2017**
(21) Anmeldenummer: 14795953.0
(22) Anmeldetag: 31.10.2014
(51) Int. Cl.: G05B 19/05, H04L 12/40, G06F 13/40, H04L 29/12, H05K 7/14

(54) **VERFAHREN ZUR IDENTIFIZIERUNG DER RELATIVEN EINBAUPOSITION DER IN EINEM MODULAREN ELEKTRONISCHEN SYSTEM ZUR VERWENDUNG KOMMENDEN MODULE**
METHOD FOR IDENTIFYING THE RELATIVE INSTALLATION POSITION OF THE MODULES USED IN A MODULAR ELECTRONIC SYSTEM
PROCÉDÉ D'IDENTIFICATION DE LA POSITION DE MONTAGE RELATIVE DES MODULES UTILISÉS DANS UN SYSTÈME ÉLECTRONIQUE MODULAIRE

(30) Priorität: 31.10.2013 DE 102013018282
(43) Veröffentlichungstag der Anmeldung: 16.09.2015
(73) Patentinhaber: TQ-Systems GmbH, 82229 Seefeld (DE); NXTControl GmbH, 2544 Leobersdorf (AT)
(72) Erfinder: TREPTE, Johannes, 82229 Seefeld (DE); MAYER, Horst, A-2540 Bad Vöslau (AT); HERRKLOTZ, Ricardo, A-2491 Neufeld (AT)
(74) Vertreter: Grättinger Möhring von Poschinger Patentanwälte Partnerschaft
(86) Internationale Anmeldenummer: PCT/EP2014/002922
(87) Internationale Veröffentlichungsnummer: WO 2015/062731

(56) Entgegenhaltungen:
- EP-A1- 0 806 751
- DE-C1- 4 038 992
- US-A1- 2005 220 127

## Beschreibung

Die vorliegende Erfindung betrifft ein Verfahren zur Identifizierung der relativen Einbauposition der in einem modularen elektronischen System zur Verwendung kommenden Module, wobei das System eine Mehrzahl an über ein Feldbussystem linear miteinander gekoppelten elektronischen Modulen, ein Netzteil und eine zentrale Steuereinheit aufweist. Ferner betrifft die Erfindung ein zur Durchführung des Verfahrens eingerichtetes modulares elektronisches System der vorstehend genannten Art.

Ein entsprechendes Verfahren und ein hierzu korrespondierendes System, bei welchem die einzelnen über ein Feldbussystem linear miteinander verbundenen Module Teil einer speicherprogrammierbaren Steuerung sind, an die dann z.B. zu steuernde Feldelemente und/oder auszulesende Sensoren anschließbar sind, sind z.B. bereits aus der nicht vorveröffentlichten DE 10 2012 023 069.9 bekannt.

Bei dem dortigen System umfasst jedes Modul einen an einer Tragschiene montierbaren Grundkörper mit daran angeordneten Anschlusselementen für Feldelemente sowie einen lösbar an dem Grundkörper montierbaren bzw. montierten Aufsatzkörper, der die Steuerelektronik des Moduls enthält. Die Stromversorgung der Module wird über entsprechende Anschlusselemente am Grundkörper hergestellt, die untereinander verbunden werden können, so dass alle hierfür in Serie miteinander zu verbindenden Module von einem Netzteil, also einer externen Stromversorgung, mit Strom versorgt werden können. Eines der Module fungiert dabei als Hauptsteuerungsmodul, also als zentrale Steuereinheit des Systems. Ferner ist durch geeignete Gestaltung der Module sichergestellt, dass die Anbindung aller Module an die Stromversorgung sowie die in linearer Kopplung der einzelnen Module erfolgende Busverbindung ausschließlich über grundkörperseitig angeordnete Komponenten / Verbindungselemente erfolgt, so dass bei Demontage des Aufsatzkörpers eines Moduls, welcher dessen Steuerelektronik beinhaltet, noch immer die Stromversorgung und Bussystemverbindung zu allen Modulen des Systems besteht.

Dabei ist mittels separater in die Grundkörper der jeweiligen Module integrierter Schaltkreise, welche ebenfalls über geeignete Verbindungselemente untereinander und mit der Steuerungselektronik des jeweiligen Moduls verbunden sind, die relative Einbauposition der einzelnen Module zum Hauptsteuerungsmodul ermittelbar. Die vorgenannten Schaltkreise der verschiedenen Module umfassen hierzu jeweils zwei von dem Hauptsteuerungsmodul angesteuerte Signalleitungen und einen Flip-Flop, mit deren Hilfe unter Aussendung eines geeigneten Taktsignals durch das Hauptsteuerungsmodul und geeigneter Antwort- bzw. Identifikationssignale durch die Steuerelektronik der einzelnen Module die relative Einbaulage der einzelnen Module ermittelbar ist.

Diese Systemgestaltung erfordert die Integration einer die Schaltkreise inkl. Flip-Flop beinhaltenden Platine in jedes einzelne Modul, was vergleichsweise aufwändig ist. Ferner erweisen sich entsprechende Schaltkreise mit Flip-Flops als nicht besonders robust bzw. fehleranfällig, was insbesondere dann von Bedeutung ist, wenn, wie dies auch vorliegend in bevorzugter Weise gewünscht ist, jedes Modul vorzugsweise einen besonders robusten und wenig fehleranfälligen Grundkörper und einen hieran lösbar montierbaren Aufsatzkörper aufweisen soll, welcher die eher fehleranfällige Steuerelektronik beinhaltet und z.B. zu Reparaturzwecken vom Grundkörper demontierbar sein soll, ohne dabei die Funktion, Stromversorgung und Kommunikation der weiteren Module des System zu unterbrechen.

Ein weiteres System der genannten Art ist aus EP 0 806 751 A1 bekannt.

Aus der US 2012/0284441 A1 ist ein weiteres System bzw. Verfahren der eingangs genannten Art bekannt, bei welchem in jedem Modul ein separater Strommesskreis vorgesehen ist. Dies ist apparativ vergleichsweise aufwändig.

Vor diesem Hintergrund ist es die Aufgabe der vorliegenden Erfindung, ein alternatives Verfahren und System der eingangs genannten Art bereitzustellen, mit welchem in besonders einfach und wenig fehleranfällig zu implementierender Weise eine Identifikation der relativen Einbauposition sämtlicher Module eines erfindungsgemäßen Systems ermöglicht wird.

Diese Aufgabe wird gelöst mit einem Verfahren gemäß Anspruch 1. Dabei ist hinsichtlich der Ausgestaltung des Systems, in welchem das erfindungsgemäße Verfahren Anwendung findet, vorgesehen, dass das System eine Mehrzahl an über ein Feldbussystem linear miteinander gekoppelten elektronischen Modulen, wenigstens ein Netzteil mit einer dem Netzteil zugeordneten Stromquelle und eine zentrale Steuereinheit aufweist. Die Module sind, gegebenenfalls segmentweise, über geeignet miteinander zu verbindende Ein- und Ausgänge der betreffenden Module in Serie an die dem wenigstens einen Netzteil zugeordnete Stromquelle angeschlossenen, wobei der Eingang und der Ausgang jedes Moduls über einen Widerstand miteinander verbunden sind. Jedes Modul weist einen Schalter auf, mit welchem der Ausgang des betreffenden Moduls mit einem Referenzpotential verbindbar ist und jeder (also der wenigstens einen einem Netzteil zugeordneten) Stromquelle ist wiederum eine Spannungserfassungseinreichung zugeordnet, mit welcher die am Ausgang der Stromquelle gegen ein Referenzpotential anliegende Spannung ermittelbar ist. Die Identifizierung der relativen Einbauposition der Module erfolgt in erfindungsgemäßer Weise dadurch, dass in einem durch geeignete Programmierung automatisch ausgeführten Verfahren zu jedem Modul des Systems eine Messung durchgeführt wird, bei der die am Ausgang der dem betreffenden Modul vorgeschalteten Stromquelle anliegende Spannung mittels der Spannungserfassungseinrichtung ermittelt wird, wobei während dieser Messung jeweils
- die dem Modul vorgeschaltete Stromquelle aktiviert ist,
- der Ausgang des betreffenden Moduls über den in das Modul integrierten Schalter mit dem Referenzpotential verbunden ist und
- die Ausgänge der übrigen Module nicht mit dem Referenzpotential verbunden sind,
wodurch sich die relative Einbauposition der Module aus einem Vergleich der dabei ermittelten Spannungen ergibt.

Selbstverständlich ist es zur Durchführung des erfindungsgemäßen Verfahrens notwendig, zu allen Netzteilen, den ggfs. hiervon separaten Stromquellen und allen an das System angeschlossenen Modulen die dem jeweiligen Gerät zugeordnete Feldbusadresse zu kennen bzw. diese in einem Initialisierungsschritt zu vergeben, um die betreffenden Geräte bzw. die darin enthaltenen Schalter bzw. Spannungsermittlungseinrichtungen entsprechend ansteuern zu können, was jedoch bei Feldbussystemen üblicher Bauart Stand der Technik ist. Vorteilhaft werden vor Durchführung des erfindungsgemäßen Verfahrens oder ggfs. in einem ersten Schritt des Verfahrens somit zunächst unter Anwendung eines geeigneten Algorithmus zunächst die Feldbusadressen aller an das System angeschlossenen Geräte (inkl. des wenigstens einen vorteilhaft auch über das Bussystem ansprechbaren Netzteils und/oder der zugehörigen Stromquelle) ermittelt bzw. bestimmt. Dieser Vorgang wird häufig auch als (Bus)Kommissionierung bezeichnet.

Entscheidend ist dabei zunächst, dass jedes an das System angeschlossene Modul eine eindeutige Feldbusadresse aufweist bzw. zugewiesen bekommt, was selbstverständlich voraussetzt, dass in jedem Modul entweder bereits eine eindeutige Feldbusadresse gespeichert oder dass eine solche am Modul einstellbar oder aus einer eindeutigen ID (UID) des betreffenden Moduls ableitbar bzw. bestimmbar ist.

Hierdurch könnte somit zunächst durch einzelne Abfragen an alle an das System angeschlossenen Module ergänzend ermittelt werden, welche Art und wie viele (gleiche oder verschiedene) Module, Netzteile (mit ggfs. integrierter oder hiervon separater Stromquelle) an das System angeschlossen sind, jedoch bleibt noch unbekannt, an welcher relativen Einbauposition sich die einzelnen Module befinden.

Das erfindungsgemäße Verfahren macht sich sodann zunutze, dass die jeweiligen Ein- und Ausgänge der verschiedenen Module (vorzugsweise innerhalb eines Grundkörpers des Moduls) über einen Widerstand miteinander verbunden sind. Bevorzugt ist im Rahmen der Erfindung vorgesehen, dass die in die verschiedenen Module integrierten Widerstände jeweils den gleichen Widerstandswert aufweisen, was letztlich jedoch nicht zwingend ist.

Wenn somit z.B. im Rahmen des erfindungsgemäßen Verfahrens an ein (beliebiges) erstes Modul des Systems eine Anweisung ausgesandt wird, dass das betreffende Modul - für einen vorgebbaren bzw. vorgegebenen Zeitraum - unter Verwendung eines geeigneten Schalters (z.B. eines MOSFET-Schalters) seinen Ausgang mit einem Referenzpotential, z.B. dem Erdpotential des Bussystems, verbinden soll, während die Ausgänge der anderen Module nicht mit dem Referenzpotential verbunden sind, so kann durch Ermittlung der sich dabei am Ausgang der Stromquelle gegen ein Referenzpotential (z.B. das Erdpotential des Bussystems) einstellenden Spannung und durch geeigneten Vergleich der diesbezüglichen Messungen für alle der betreffenden Stromquelle nachgeschalteten Module des Systems eine Aussage zur relativen Einbauposition des betreffenden Moduls getroffen werden.

Handelt es sich bei dem entsprechend adressierten Modul z.B. um das zweite Modul aus einer in Serie hinter der Stromquelle angeschlossenen Kette von Modulen, so registriert die Spannungserfassungseinrichtung am Ausgang der Stromquelle eine Spannung, die durch das Produkt des von der Stromquelle bereitgestellten Stroms und der Summe der im ersten und zweiten Modul integrierten Widerstände bestimmt ist. Bei identischen Widerständen in allen Modulen entspricht die sich beim Aufruf eines Moduls am Ausgang der Stromquelle einstellende Spannung also jeweils (exakt) dem Produkt des bereitgestellten Strom, des (für alle Module identischen) Widerstandswerts und der relativen Einbauposition des betreffenden Moduls hinter der betreffenden Stromquelle.

Werden solche Messungen nun für alle an das System angeschlossenen Stromquellen und Module wiederholt, so ergeben sich für die den verschiedenen Modulen zugeordneten Spannungen entsprechend unterschiedliche Werte, so dass z.B. durch geeignete Sortierung der für die verschiedenen Module ermittelten Spannungen und der zugehörigen Feldbusadressen eindeutig ermittelt werden kann, welches (über seine Feldbusadresse identifiziertes) Modul an welcher Einbauposition des Systems hinter einer bestimmten Stromquelle verbaut ist.

Die im Rahmen des erfindungsgemäßen Verfahrens vollautomatisch gewinnbare Kenntnis von den relativen Einbauposition aller an das System angeschlossener Module ist im Vergleich zu der aus dem Stand der Technik bekannten manuellen Zuordnung von Moduladressen zu physikalischen Positionen weniger fehleranfällig und weniger zeitintensiv. Ferner kann die automatische Ermittlung der relativen Einbauposition aller Module z.B. dazu genutzt werden, dasjenige Modul zu identifizieren, welches als letztes Modul in der Kette von Modulen angeordnet ist. Diesem letzten Modul kann dann z.B. eine Anweisung zur Terminierung des die Module verbindenden Bussystems übermittelt werden, was z.B. durch eine automatisch erfolgende Hinzuschaltung eines hierfür erforderlichen Abschlusswiderstands erfolgen kann und was bisher im Stand der Technik entweder manuell oder mittels aufwendigerer Systeme erfolgt. Ferner kann z.B. im Fall von etwaigen Fehlermeldungen durch die zentrale Steuereinheit die Einbauposition des von der Fehlermeldung betroffenen Moduls angezeigt (oder sonst wie mitgeteilt) werden, so dass ein bestimmtes, im Stand der Technik nur über seine Feldbusadresse identifizierbares Modul für einen Nutzer einfacher auffindbar ist.

Im Rahmen der konkreten Realisierung eines erfindungsgemäßen Verfahrens ist zu unterscheiden zwischen Systemen, bei denen aufgrund der Systemspezifikation bzw. bauartbedingt sichergestellt ist, dass alle Module des Systems von einer einzigen Stromquelle mit Strom versorgt werden, und solchen - demgegenüber besser erweiterbaren - Systemen, bei denen die Möglichkeit zur Hinzufügung weiterer Netzteile mit zugeordneter Stromquelle besteht, so dass im Ergebnis unter Verwendung mehrer Netzteile/Stromquellen jeweils eine Mehrzahl an Modulen in segmentweiser Anordnung zusammengeschaltet werden können.

In einer ersten Ausführungsvariante betrifft die vorliegende Erfindung somit ein vorstehend erläutertes Verfahren zur Identifizierung der relativen Einbauposition der in einem modularen elektronischen System zur Verwendung kommenden Module, wobei das System bauartbedingt genau ein Netzteil mit einer dem Netzteil zugeordneten Stromquelle aufweist und wobei das Verfahren die folgenden, durch geeignete Programmierung automatisch auszuführenden Schritte umfasst:
(A1) Ermittlung und/oder Bestimmung der Feldbus-Adressen aller an das Feldbussystem angeschlossenen Module durch die zentrale Steuereinheit, so dass alle an den Feldbus angeschlossenen Module durch die Steuereinheit individuell ansprechbar sind
(B1) Aussenden einer Anweisung an ein an das Feldbussystem angeschlossenes Modul, seinen Ausgang für einen vorgegebenen Zeitraum unter Verwendung des in dem betreffenden Modul verbauten Schalters mit dem Referenzpotential zu verbinden, wobei innerhalb dieses Zeitraums die sich dabei jeweils am Ausgang der Stromquelle gegenüber dem Referenzpotential einstellende Spannung mittels der der Stromquelle zugeordneten Spannungserfassungseinrichtung ermittelt wird, und wobei nach Abschluss des vorgegebenen Zeitraums oder in Reaktion auf eine entsprechende Anweisung der Ausgang des Moduls wieder von dem Referenzpotential getrennt wird
(C1) Wiederholung des Schrittes (B1) für alle weiteren an das Feldbussystem angeschlossenen Module
(D1) Identifizierung der relativen Einbauposition aller über die dem Netzteil zugeordneten Stromquelle mit Strom versorgten Module anhand der in Schritt (B1) ermittelten und den verschiedenen Modulen zugeordneten Spannungen.

Hierbei werden also bei einem System mit genau einem Netzteil mit zugeordneter Stromquelle und diesen nachgeschalteten Modulen zunächst die Feldbusadressen aller Busteilnehmer bestimmt und anschließend sukzessive Messungen der sich am Ausgang der Stromquelle einstellenden Spannungen vorgenommen, während derer stetes jeweils genau ein bestimmtes Modul seinen Ausgang auf das Referenzpotential legt. Aufgrund des bei den verschiedenen Messungen unterschiedlichen Spannungsabfalls kann dann auf die physikalische Adresse / relative Einbauposition der einzelnen Module geschlossen werden.

Wie bereits weiter oben bereits erwähnt, ist die vorliegende Erfindung jedoch auch auf Systemgestaltungen anwendbar, bei denen die verschiedenen Module des Systems ggfs. in segmentweiser Anordnung von mehr als einem Netzteil mit zugeordneter Stromquelle mit Strom versorgt werden können, wodurch ersichtlich eine alternative Ausgestaltung des erfindungsgemäßen Verfahrens Anwendung finden muss, da hier die Relativposition der einzelnen Module stets nur in Bezug auf die die betreffenden Module mit Strom versorgenden Stromquellen, also nur segmentweise, erfolgen kann und zur vollständigen Bestimmung der relativen Einbauposition aller Module auch die Reihenfolge der einzelnen Netzteile bzw. der diesen zugeordneten Stromquellen ermittelt werden muss.

Die vorliegende Erfindung betrifft daher in einer zweiten Verfahrensvariante auch ein Verfahren erfindungsgemäßer Art, wobei das zur Durchführung des Verfahrens bestimmte System bauartbedingt eine segmentweise Anordnung von Netzteilen mit jeweils dem betreffenden Netzteil zugeordneter Stromquelle und Modulen gestattet. Dabei weist dann jedes Segment genau ein Netzteil mit zugeordneter Stromquelle und wenigstens ein Modul auf, wobei die einzelnen Segmente derart in Serie miteinander zu verbinden sind, dass der Ausgang des letzten Moduls eines ersten Segments mit einem an dem Netzteil oder der Stromquelle des nachfolgenden Segments vorgesehenen Segmenteingang verbunden ist. Für diese Verfahrensvariante ist zudem vorgesehen, dass jedem Netzteil mit zugeordneter Stromquelle eine zweite Spannungserfassungseinrichtung zugeordnet ist, mit welcher die am Segmenteingang gegen ein Referenzpotential anliegende Spannung ermittelbar ist, wobei auch dieses Referenzpotential vorteilhaft durch das Erdpotential des Bussystems vorgegeben sein kann. Die zweite Verfahrensvariante umfasst sodann die folgenden, durch geeignete Programmierung automatisch auszuführenden Schritte:
(A2.1) Ermittlung und/oder Bestimmung der Feldbus-Adressen aller an das Feldbussystem angeschlossenen Netzteile mit zugeordneter Stromquelle und Module durch die zentrale Steuereinheit, so dass alle an den Feldbus angeschlossenen Netzteile, Stromquellen und Module durch die Steuereinheit individuell ansprechbar sind
(A2.2) Aussenden einer Anweisung zum Einschalten aller Stromquellen des Systems
(A2.3) Ermittlung der an allen Segmenteingängen anliegenden Spannung mittels der hierfür vorgesehenen Spannungserfassungseinrichtung, wobei durch Ermittlung desjenigen Segmenteingangs, an dem keine Spannung anliegt, das dem betreffenden Segmenteingang zugeordnete Netzteil und die zugehörige Stromquelle als Netzteil bzw. Stromquelle des ersten Segments identifiziert werden
(A2.4) Aussenden einer Anweisung zur Abschaltung aller Stromquellen mit Ausnahme der dem Netzteil des ersten Segments zugeordneten Stromquelle
(B2) Aussenden einer Anweisung an ein an das Feldbussystem angeschlossenes Modul, seinen Ausgang für einen vorgegebenen Zeitraum unter Verwendung des in dem betreffenden Modul verbauten Schalters mit dem Referenzpotential zu verbinden, wobei innerhalb dieses Zeitraums die sich dabei jeweils am Ausgang der Stromquelle des ersten Segments gegenüber dem Referenzpotential einstellende Spannung mittels der hierfür vorgesehenen Spannungserfassungseinrichtung ermittelt wird, und wobei nach Abschluss des vorgegebenen Zeitraums oder in Reaktion auf eine entsprechende Anweisung der Ausgang des Moduls wieder von dem Referenzpotential getrennt wird
(C2) Wiederholung des Schrittes (B2) für alle weiteren an das Feldbussystem angeschlossenen Module
(D2) Identifizierung aller in dem ersten Segment über die dortige Stromquelle mit Strom versorgten Module und ihrer relativen Einbauposition zur Stromquelle des ersten Segments anhand der in Schritt (B2) ermittelten und den verschiedenen Modulen zugeordneten Spannungen
(E2) Aussenden einer Anweisung zum Einschalten aller Stromquellen des Systems mit Ausnahme derjenigen Stromquellen, die ein Segment des Systems mit Strom versorgen, zu welchem bereits gemäß Schritt (D2) eine Identifizierung aller in dem betreffenden Segment angeordneten Module durchgeführt wurde
(F2) Ermittlung der an allen noch nicht einem bestimmten Segment zugeordneten Segmenteingängen anliegenden Spannung, wobei entweder dasjenige Netzteil bzw. diejenige Stromquelle, an deren Segmenteingang keine Spannung anliegt, als Netzteil bzw. Stromquelle des auf das vorherige Segment folgenden Segments identifiziert wird oder, falls kein solches Netzteil bzw. keine solche Stromquelle mehr existiert, das Verfahren beendet wird
(G2) Wiederholung der Schritte (A2.4) - (F2), wobei in diesen Verfahrensschritten an die Stelle der Stromquelle des ersten Segments diejenige Stromquelle tritt, die gemäß Schritt (F2) als Stromquelle des auf das vorherige Segment folgenden Segments identifiziert wurde, bis alle je ein Netzteil mit zugeordneter Stromquelle aufweisenden Segmente und die daran jeweils angeschlossenen Module erfasst wurden.

Bei diesem Verfahren, welches später anhand der Zeichnung nochmals näher erläutert wird, wird also die Einbauposition der verschiedenen Module segmentweise, d.h. jeweils in Bezug auf die in den einzelnen Segmenten einem Netzteil bzw. einer Stromquelle nachgeschalteten Module, ermittelt.

Nach Durchführung der Buskommissionierung gemäß Schritt (A2.1), in deren Rahmen z.B. auch Netzteile bzw. Stromquellen als solche identifiziert werden können, und nach Ermittlung des ersten Netzteils bzw. der ersten Stromquelle des Systems, welche als dem ersten Segment zugehörig identifiziert werden, werden zunächst - bei ausschließlicher Aktivierung der Stromquelle des ersten Segments - die relativen Einbaupositionen aller der betreffenden Stromquelle innerhalb des Segments nachgeschalteten Module bestimmt. Soweit dabei im Rahmen der Ermittlung der am Ausgang der Stromquelle anliegenden Spannungswerte gemäß Schritten (B2) und (C2) auch die in anderen Segmenten verbauten Module angewiesen werden, ihren jeweiligen Ausgang auf ein Referenzpotential (vorteilhaft des Erdpotential des Busses), zu legen, so kann aus der dabei jeweils am Ausgang der Stromquelle des ersten Segments gemessenen Spannung erkannt werden, ob es sich um ein innerhalb des ersten Segments befindliches Modul oder um ein Modul eines anderen Segments handelt. In letzterem Fall liegt nämlich bei keinem Modul des ersten Segments dessen Ausgang auf Erdpotential, so dass für nicht dem ersten Segment zugehörige Module hier stets die Leerlaufspannung der Stromquelle des ersten Segments gemessen wird. Für innerhalb des ersten Segments angeordnete Module ergeben sich hingegen die bereits weiter oben erläuterten - in Abhängigkeit von deren relativer Einbaulage abgestuften - Spannungsmesswerte, die den gewünschten Rückschluss auf deren jeweilige Einbauposition innerhalb des Segments zulassen.

Sodann wird die Stromquelle des ersten Segments deaktiviert und alle anderen ggfs. vorhandenen Netzteile bzw. Stromquellen eingeschalten, wodurch ermittelbar ist, ob überhaupt weitere Netzteile/Stromquellen (und somit weitere Segmente) existieren und, falls dem so ist, welches Netzteil bzw. welche Stromquelle dem zweiten Segment zugehörig ist.

Sodann werden unter ausschließlicher Aktivierung der Stromquelle des zweiten Segments und unter erneuter Anwendung des bereits beschriebenen Verfahrens die relativen Einbaulagen aller Module des zweiten Segments ermittelt. Diese Vorgehensweise wird sodann iterativ fortgesetzt, bis klar ist, dass das System keine weiteren Netzteile/Stromquellen (und diesen nachgeschaltete Module) mehr aufweist, womit das Verfahren nach erfolgter Ermittlung der relativen Einbaupositionen aller Module (und Netzteile/Stromquellen) erfolgreich abgeschlossen ist.

Mit dem vorstehend beschriebenen Verfahren lässt sich auf zuverlässige Art und Weise die relative Einbauposition aller Busteilnehmer bestimmen, wobei eine quadratisch mit der Anzahl an Modulen wachsende Laufzeitkomplexität des dabei zur Anwendung kommenden Algorithmus' vorliegt. Ferner muss bei dem vorgenannten Verfahren zu jeder Stromquelle eine zweite - nämlich segmenteingangsseitig angeordnete - Spannungserfassungseinrichtung vorgesehen sein, was sich als vergleichsweise kostenintensiv erweist.

Daher betrifft eine dritte Verfahrensvariante des erfindungsgemäßen Verfahrens ein demgegenüber nochmals verbessertes Verfahren, welches ebenfalls für Systeme mit segmentweiser Anordnung von Netzteilen/Stromquellen und Modulen Anwendung finden kann. Dabei muss an jeder Stromquelle bzw. jedem Netzteil anstelle der segmenteingangsseitigen Spannungserfassungseinrichtung lediglich ein - demgegenüber günstigerer - Schalter (z.B. ein MOSFET-Schalter) vorgesehen sein, über den der Segmenteingang mit einem Referenzpotential (insbesondere dem Erdpotential des Busses) verbindbar ist. Diese dritte Verfahrensvariante ist durch die nachfolgenden Schritte gekennzeichnet, die im Übrigen in besonders vorteilhafter Weise eine lediglich linear mit der Anzahl an Modulen anwachsende Laufzeit verursachen:
(A3.1) Ermittlung und/oder Bestimmung der Feldbus-Adressen aller an das Feldbussystem angeschlossenen Netzteile mit zugeordneter Stromquelle und Module durch die zentrale Steuereinheit, so dass alle an den Feldbus angeschlossenen Netzteile, Stromquellen und Module durch die Steuereinheit individuell ansprechbar sind
(A3.2) Aussenden einer Anweisung zum Einschalten aller Stromquellen des Systems und zum Verbinden aller Segmenteingänge mit dem Referenzpotential
(A3.3) Ermittlung der an allen Ausgängen aller Stromquellen anliegenden Spannung mit der hierfür jeweils vorgesehenen Spannungserfassungseinrichtung, wobei diejenige Stromquelle, an deren Ausgang die Leerlaufspannung der Stromquelle gemessen wird, als Stromquelle des letzten Segments des Systems identifiziert wird, und anschließendes Aussenden einer Anweisung zum Trennen des Segmenteingangs des letzten Segments von dem Referenzpotential (mittels des hierfür vorgesehenen Schalters)
(A3.4) Ermittlung der an allen Ausgängen der bisher nicht einem bestimmten Segment zugeordneten Stromquellen anliegenden Spannung mit der hierfür jeweils vorgesehenen Spannungserfassungseinrichtung, wobei diejenige Stromquelle, an deren Ausgang die Leerlaufspannung der Stromquelle gemessen wird, als Stromquelle des letzten Segments des verbleibenden System identifiziert wird und anschließendes Aussenden einer Anweisung zum Trennen des Segmenteingangs des vorgenannten Segments von dem Referenzpotential
(A3.5) Wiederholen des Schrittes (A3.4) bis die Reihenfolge der den einzelnen Segmenten des Systems zugeordneten Stromquellen und der zugehörigen Netzteile feststeht
(B3) Aussenden einer Anweisung an ein an das Feldbussystem angeschlossenes Modul, seinen Ausgang für eine gewisse Zeit unter Verwendung des hierfür vorgesehenen Schalters mit dem Referenzpotential zu verbinden, wobei gleichzeitig die sich am Ausgang aller Stromquellen gegenüber dem Referenzpotential einstellenden Spannungen mittels der hierfür jeweils vorgesehenen Spannungserfassungseinrichtung ermittelt werden
(C3) Identifizieren derjenigen Stromquelle, an der sich durch die Schaltvorgänge gemäß Schritt (B3) eine Spannungsänderung ergibt
(D3) Abspeichern eines Datensatzes, welcher die Identität des in Schritt (B2) adressierten Moduls, die Identität der in Schritt (C3) identifizierten Stromquelle und den Wert der am Ausgang der vorgenannten Stromquelle gegen das Referenzpotential gemessenen Spannung enthält, die sich in demjenigen Zeitraum ergab, in dem der Ausgang des betreffenden Moduls über den Schalter mit dem Referenzpotential verbunden war
(E3) Wiederholen der Schritte (B3) bis (D3) für alle an das Feldbussystem angeschlossenen Module, so dass in den abgespeicherten Datensätzen jedem Modul eine spezifische Stromquelle und eine spezifische Spannung zugeordnet sind
(F3) Auswertung der abgespeicherten Datensätze zur Identifizierung der relativen Einbauposition aller Netzteile mit zugeordneten Stromquellen und aller Module

Bei dieser Verfahrensvariante wird somit nach der Buskommissionierung gemäß Schritt (A3.1) zunächst mittels der Schritte (A3.2) bis (A3.5) zunächst die Reihenfolge der im System vorhandenen Netzteile bzw. Stromquellen - beginnend mit dem Netzteil bzw. der Stromquelle des letzten Segments - bestimmt. Sodann werden sukzessive alle Module angewiesen ihren Ausgang für eine gewisse Zeit mit dem Referenzpotential zu verbinden, wobei dann durch gleichzeitige Messungen/Auswertungen des Spannungsabfalls an den jeweiligen Ausgängen aller Stromquellen und späteren Vergleich dieser in Form von Datensätzen geeignet abgespeicherten Messwerten ermittelbar ist, in welchem Segment und an welcher relativen Einbauposition innerhalb des betreffenden Segments das jeweilige Modul angeordnet ist, so dass mit dieser Verfahrensvariante - mit lediglich linear mit der Anzahl an Modulen wachsenden Laufzeitkomplexität - die physikalischen Adressen aller Busteilnehmer ermittelbar sind.

Wie bereits weiter oben an verschiedenen Stellen ausgeführt, werden die verschiedenen Referenzpotentiale vorteilhaft jeweils durch ein Erdpotential, bevorzugt durch das vom Bus bereitgestellte Erdpotential gebildet.

Wenngleich die jeweiligen Stromquellen grundsätzlich auch getrennt von den jeweiligen Netzteilen ausgebildet und ggfs. separat an das Bussystem angebunden sein können, so ist besonders bevorzugt vorgesehen, dass die jeweils einem Netzteil zugeordneten Stromquellen in das betreffende Netzteil integriert sind und somit von der Steuereinheit über das betreffende Netzteil angesprochen werden können. Soweit also im Rahmen der vorliegenden Erfindung vom Ausgang einer Stromquelle gesprochen wird, so kann dieser Ausgang durch einen (geräteintern mit dem Ausgang der Stromquelle verbundenen) Ausgang des Netzteils gebildet sein. Entsprechend kann dann der jeweilige "Segmenteingang" durch einen Eingang des Netzteils gebildet sein, der - sofern es sich nicht um das Netzteil des ersten Segments handelt - mit dem Ausgang des letzten Moduls des vorgeschalteten Segments zu verbinden ist.

Wie bereits weiter oben ausgeführt, kann in einer bevorzugten Ausgestaltung der Erfindung vorgesehen sein, dass das Feldbussystem ein CAN-Bus ist. Ferner kann die Ermittlung bzw. Bestimmung (Vergabe) der Feldbusadressen aller Busteilnehmer (Module, Netzteile, ggfs. Stromquellen) im Sinne der vorstehend genannten Schritte (A.1) bzw. (A2.1) bzw. (A3.1) dann gemäß dem für den CAN-Bus entwickelten FastScan-Algorithmus erfolgen, wobei insoweit selbstverständlich auch spezifische Adaptionen des FastScan-Algorithmus denkbar sind, soweit das bezweckte Ziel erreicht wird. Dieser Algorithmus wurde von der CiA (CAN in Automation) zur Verwendung in typischen CANopen-Umgebungen veröffentlicht. Er beruht auf so genannten "Broadcast Messages", die von der zentralen Steuereinheit des Systems, welche ggfs. mit vorteilhaft separater Stromversorgung in eines der Module integriert sein kann, ausgesendet werden, und der Auswertung der hierzu ergehenden Antwortsignale der Busteilnehmer. Nach Ablauf des FastScan-Algorithmus ist bekannt, wie viele Busteilnehmer unter welchen Feldbus-adressen (CAN-Adressen) an das System angeschlossen sind. Ggfs. kann dann eine erste Abfrage erfolgen, um welche Art von Modulen bzw. Netzteilen es sich bei den jeweiligen Busteilnehmern handelt.

Ferner bezieht sich eine besonders bevorzugten Ausführungsvariante des erfindungsgemäßen Verfahrens auf ein System, bei dem jedes Modul einen Grundkörper und einen hiermit lösbar verbindbaren Aufsatzkörper aufweist, wobei sämtliche Komponenten zur Verbindung der Module über das Feldbussystem und zur Herstellung der Verbindung der Module inklusive des Widerstands zwischen Eingang und Ausgang der jeweiligen Module grundkörperseitig angeordnet sind und wobei die (über das Bussystem ansprechbare) Steuerelektronik jedes Moduls aufsatzkörperseitig angeordnet ist.

Hierdurch kann bei einem zur Durchführung des erfindungsgemäßen Verfahrens geeigneten System gewährleistet werden, dass grundkörperseitig kein Bedarf zum Einbau einer Platine besteht und stattdessen lediglich eine - über eine Widerstand erfolgende - Verbindung zwischen Ein- und Ausgang der jeweiligen Module bereitgestellt werden muss, was in besonders kostengünstiger und robuster Weise möglich ist und sich auch im späteren Betrieb als wenig fehleranfällig erweist. Auf einer Baustelle kann somit zunächst der robuste Grundkörper der Module installiert werden und erst nach abschließender Reinigung die die Steuerelektronik beinhaltenden Aufsatzkörper aufgesteckt werden.

Ferner ist anzumerken, dass bei dem erfindungsgemäßen Verfahren in dieser Variante sogar erkennbar ist, wenn bei einem einzelnen - z.B. in Schritt (A1) bzw. (A2.1) bzw. (A3.1) oder in einem vorangehenden Verfahrensdurchlauf identifizierten - Modul der die Steuerelektronik des betreffenden Moduls beinhaltende Aufsatzkörper zwischenzeitig entfernt wurde. Ein solch leerer Grundkörper (d.h. ohne Aufsatzkörper) kann nämlich bei entsprechender Anweisung an das betreffende Modul wegen der fehlenden Steuerelektronik gemäß Schritt (B1) bzw. (B2) seinen Ausgang nicht auf das Referenzpotential (Erdpotential des Bussystems) ziehen, so dass in diesem Fall am Ausgang der Stromquelle bzw. des die Stromquelle beinhaltenden Netzteils eine höhere Spannungsstufe als die bei vorhandener Steuerelektronik zu erwartende Spannung erfasst wird.

Insoweit kann das erfindungsgemäße Verfahren bei Systemen der vorliegend relevanten Art bevorzugt auch wiederholt durchgeführt werden, um etwaige Änderungen der Systemkonfiguration erkennen zu können. Es wird also bevorzugt nach jeder Änderung der Systemkonfiguration durchgeführt, um stets aktuell die relative Einbauposition aller Module des Systems zu kennen.

Und schließlich betrifft die vorliegende Erfindung auch ein zur Durchführung des erfindungsgemäßen Verfahrens eingerichtetes System
entsprechend Anspruch 10. Selbstverständlich gelten alle weiter oben bereits erläuterten Aspekte, Ausführungsvarianten, Vorteile und bevorzugten Weiterbildungen des erfindungsgemäßen Verfahrens in gleicher Weise auch für das erfindungsgemäße System, so dass zur Vermeidung von Wiederholungen hierauf verwiesen wird.

Das erfindungsgemäße System und Verfahren lassen sich insbesondere in vernetzten Steuerungssystemen implementieren, unabhängig davon, ob die hierbei zur Verwendung kommenden Steuerungsmodule z.B. alle innerhalb eines Schaltschranks oder über mehrere Schaltschränke oder gar verschiedene Gebäude verteilt angeordnet sind. Die Verbindung zwischen den einzelnen Modulen und Netzteilen/Stromquellen kann neben Kontaktsystemen (z.B. in Form von direkt miteinander zu koppelnden Verbindungssteckern) auch über Kabel oder sonstige Leitungen erfolgen.

Nachfolgend wird ein Ausführungsbeispiel des erfindungsgemäßen Verfahrens anhand der Zeichnung näher erläutert. Dabei zeigt
- Fig. 1: eine schematische Teilansicht eines Ausführungsbeispiels eines erfindungsgemäßen Systems,
- Fig. 2: ein Ablaufdiagramm zu einem ersten Ausführungsbeispiel des erfindungsgemäßen Verfahrens,
- Fig. 3: ein Ablaufdiagramm zu einem zweiten Ausführungsbeispiel des erfindungsgemäßen Verfahrens und
- Fig. 4: ein Ablaufdiagramm zu einem dritten Ausführungsbeispiel des erfindungsgemäßen Verfahrens.

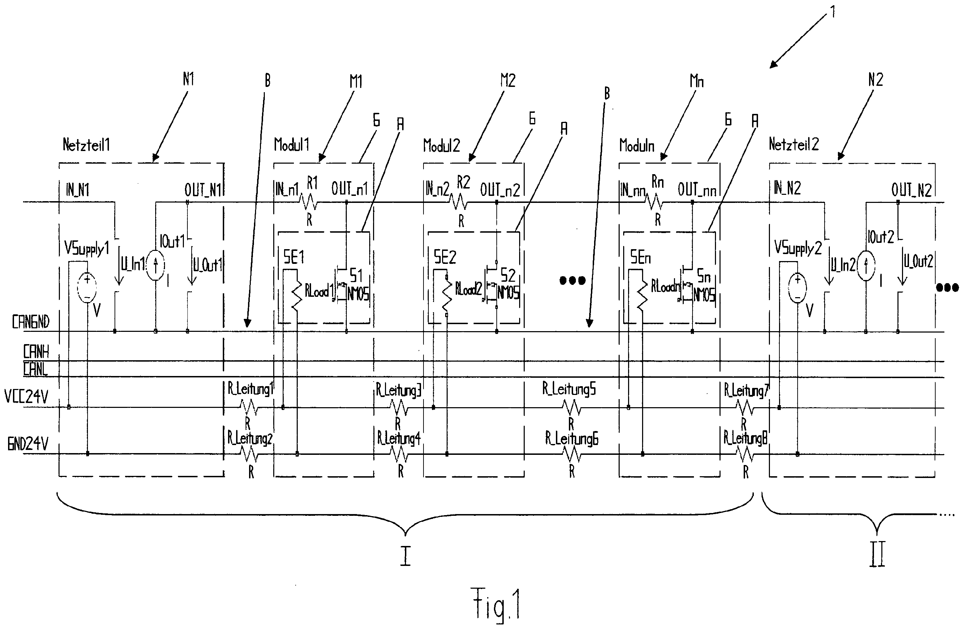

Fig. 1 zeigt in schematischer Ansicht einen Ausschnitt eines erfindungsgemäßen und zur Durchführung des erfindungsgemäßen Verfahrens geeigneten Systems 1. Dargestellt ist, dass das System 1 vorliegend ein erstes Netzteil N1 aufweist, welchem in Serie eine Mehrzahl n an Modulen M1, M2, ..., Mn nachgeschaltet sind. Das erste Netzteil N1 und die diesem unmittelbar nachgeschalteten Module M1, M2, ..., Mn bilden ein erstes Segment I des Systems 1. Diesem folgt ein zweites Netzteil N2 des Systems 1, welchem dann - was der Übersichtlichkeit halber nicht dargestellt ist - wiederum eine Mehrzahl weiterer Module nachgeschaltet sein können, die dann gemeinsam mit dem zweiten Netzteil N2 ein zweites Segment II des Systems 1 bilden. Entsprechend können bei einem erfindungsgemäßen System 1 in entsprechend segmentweiser Anordnung weitere Segmente aus je einem Netzteil und einer Mehrzahl an Modulen zugeschaltet werden.

Jedes Netzteil N1, N2 und jedes Modul M1, M2, ..., Mn weisen jeweils einen Eingang IN_N1 (Segmenteingang), IN_N2 (Segmenteingang), IN_n1, IN_n2, ..., IN-nn und einen Ausgang OUT_N1, OUT_N2, OUT_n1, OUT_n2, .., OUT_nn auf, die mit dem hierzu jeweils korrespondierenden Aus- bzw. Eingang des dem jeweiligen Modul bzw. Netzteil benachbarten Moduls bzw. Netzteils auf geeignete Weise, z.B. durch eine Steckverbindung oder geeignete Verbindungskabel verbunden sind. Alle Module M1, M2, ..., Mn eines jeden Segments I, II können hierdurch in Serie durch die jeweilige Stromquelle IOUT1, IOUT2 des dem jeweiligen Segment zugeordneten Netzteils N1, N2 mit einem von der jeweiligen Stromquelle IOUT1, IOUT2 bereitgestellten Strom I versorgt werden.

Der Eingang IN_n1, IN_n2, ..., IN_nn und der jeweilige Ausgang OUT_n1, OUT_n2, .., OUT_nn aller Module M1, M2, ..., Mn sind innerhalb des betreffenden Moduls über einen dazwischen geschalteten Widerstand R1, R2, ..., Rn mit identischem Widerstandswert R miteinander verbunden.

Jedes Netzteil N1, N2 weist zwei Spannungserfassungseinrichtungen auf, mit welchen die am jeweiligen Segmenteingang IN_N1, IN_N2 und die am jeweiligen Ausgang OUT_N1, OUT_N2 jeweils anliegenden Spannungen U_In1, U_In2, U_Out1, U_Out2 ermittelbar sind.

Die Module M1, M2, ... Mn des Systems sowie die je eine Stromquelle IOUT1, IOUT2 beinhaltenden Netzteile N1, N2 des Systems 1 sind in linearer Kette entsprechend der bereits weiter oben erläuterten segmentweisen Anordnung an ein - vorliegend auf dem CAN-Bus-Standard basierendes - Feldbussystem B angeschlossen, welches im vorliegenden Ausführungsbeispiel eine das Erdpotential des Bussystems B bereitstellende Leitung CANGND sowie die Signalleiter CANH und CANL umfasst. Ferner umfasst das Feldbussystem, was allerdings optional ist, die beiden eine Busspannung von 24V bereitstellenden Versorgungsleitungen VCC24V und GND24V, welche mit den Spannungsquellen VSupply1 und VSupply2 der verschiedenen Netzteile N1, N2 verbunden sind und zur Versorgung der jeweiligen, eine Last RLoad1, RLoad2, ..., RLoadn darstellenden Steuerelektronik SE1, SE2, ... SEn der verschiedenen Module M1, M2, ..., Mn dienen. Es sei jedoch darauf hingewiesen, dass in anderen Ausführungsvarianten der vorliegenden Erfindung neben Modulen, deren Steuerungselektronik sich wie dargestellt aus der Busspannung versorgt, auch (energieautarke) Module Verwendung finden können, die sich unabhängig von der Busspannung, z.B. durch eine andere externe Spannungsquelle versorgen können.

Jedes Modul M1, M2, ... Mn besteht aus zwei lösbar miteinander verbindbaren Teilen, nämlich einem Grundkörper G und einem hierauf aufsteckbaren Aufsatzkörper A, was in Fig. 1 durch gestrichelte Rechtecke veranschaulicht ist. Sowohl die Netzverbindung als auch die Busverbindung der einzelnen Module ist in die jeweiligen Grundkörper G integriert. Die jeweilige Steuerelektronik SE1, SE2, ..., SEn der verschiedenen Module M1, M2, ..., Mn ist demgegenüber im z.B. zu Reparaturzwecken hiervon abnehmbaren Aufsatzkörper A angeordnet. Gleichermaßen ist vorliegend ein in allen Modulen M1, M2, ..., Mn enthaltener Schalter S1, S2, ..., Sn, mit welchem der jeweilige Ausgang OUT_n1, OUT_n2, .., OUT_nn der verschiedene Module mit dem als Referenzpotential fungierenden Erdpotential CANGND des Bussystems B verbindbar ist, im Aufsatzkörper A der Module angeordnet.

Eine (nicht dargestellte) zentrale Steuereinheit, kann z.B. als separater Busteilnehmer links des in Fig. 1 dargestellten Netzteils N1 an das Feldbussystem B angeschlossen oder in eines der Module M1, ..., Mn integriert sein.

Diese in Fig. 1 dargestellte Systemgestaltung ermöglicht es im erfindungsgemäßen Sinne, nämlich gemäß der weiter oben erläuterten zweiten Ausführungsvariante des erfindungsgemäßen Verfahrens, für jedes an das System angeschlossenes Modul M1, ..., Mn (und jedes Netzteil N1, N2) dessen relative Einbauposition im Bus zu erkennen. Dabei wird zunächst im Rahmen der Buskommissionierung gemäß Schritt (A2.1), die z.B. unter Anwendung des FastScan-Algorithmus erfolgen kann, eine individuelle Busadresse für alle Busteilnehmer bestimmt, so dass diese einzeln ansprechbar sind. Ersichtlich muss jedoch die Buskommissionierung nicht zwingend Bestandteil eines erfindungsgemäßen Verfahrens sein, sondern kann ggfs. auch bereits zuvor stattgefunden haben, sofern sich seither die Systemkonfiguration nicht verändert hat. Sodann werden gemäß Schritt (A2.2) über eine von der zentralen Steuereinheit zu versendende Broadcast-Message die Stromquellen IOut1, IOut2 aller Netzteile N1, N2 eingeschaltet. Gemäß Schritt (A2.3) wird sodann unter Ermittlung der am Segmenteingang IN_N1, IN_N2 aller Netzteile N1, N2 anliegenden Spannungen U_In1, U_In2 festgestellt, dass lediglich an dem in Fig. 1 links dargestellten Netzteil N1 eingangsseitig keine Spannung anliegt (weil kein weiteres Netzteil/Segment davor angeschlossen ist), so dass dieses als Netzteil N1 des ersten Segments I bzw. die darin verbaute Stromquelle IOut1 als Stromquelle des ersten Segments I erkannt wird. Über eine weitere Broadcast-Message werden sodann gemäß Schritt (A2.4) alle Stromquellen mit Ausnahme der Stromquelle IOut1 des ersten Netzteils N1 ausgeschaltet. Gemäß den Schritten (B2) und (C2) erhalten sodann iterativ alle an das Feldbussystem B angeschlossenen Module M1, ..., Mn über eine CAN-Message die Anweisung, unter Verwendung des in ihnen verbauten Schalters S1, S2, ..., Sn kurzzeitig ihren jeweiligen Ausgang OUT_n1, OUT_n2, ..., OUT_nn mit dem Erdpotential CANGND des Bussystems B zu verbinden. Aufgrund des durch die Stromquelle IOut1 eingespeisten Stroms I stellt sich dabei am Ausgang OUT_N1 der Stromquelle IOut1 des Netzteils N1 des ersten Segments I eine Spannung ein, die I * R * "Position des Moduls" beträgt, wodurch nach Wiederholung des Schrittes (B2) für alle Module des Systems 1 gemäß Schritt (D2) die relative Einbauposition aller im ersten Segment I angeordneten Module M1, ..., Mn identifiziert werden kann. Nicht segmentzugehörige Module können dadurch identifiziert werden, dass bei deren Adressierung am Ausgang OUT_N1 des Netzteils N1 die Leerlaufspannung der Stromquelle IOut1 des Netzteils N1 ermittelt bzw. gemessen wird.

Dabei sei im Übrigen angemerkt, dass etwaige Spannungsabfälle durch Längswiderstände (R_Leitungx), die durch Stromaufnahme der einzelnen Module entstehen können, die vorstehende Spannungsmessung nicht beeinträchtigen, da sich alle Spannungswerte vorteilhaft auf das nur geringfügig belastete Erdpotential CANGND des Bussystems B beziehen.

Sodann werden gemäß Schritt (E2) durch geeignete CAN-Messages alle Netzteile mit Ausnahme derjenigen Netzteile, deren Segment bereits "gescannt" wurde, angewiesen, ihre jeweiligen Stromquellen einzuschalten, so dass ausschließlich am Eingang des Netzteils des ersten noch nicht "gescannten" Segments keine Spannung anliegt, womit dieses gemäß Schritt (F2) als Netzteil des auf das zuvor gescannte Segment folgenden Segments identifiziert wird, woraufhin - unter ausschließlicher Aktivierung der Stromquelle des betreffenden Netzteils - und unter Wiederholung der Verfahrensschritte im oben genannten Sinn die Einbauposition der weiteren ggfs. vorhandenen Module des betreffenden Segments ermittelbar sind. Dies wird sodann iterativ wiederholt, bis kein weiteres Netzteil bzw. Modul mehr vorhanden ist.

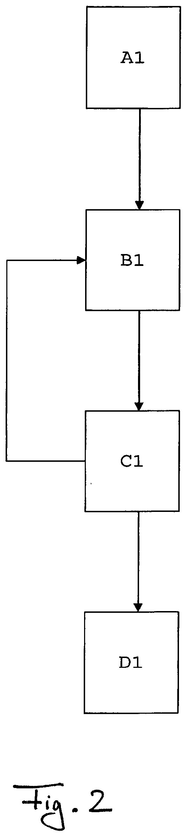

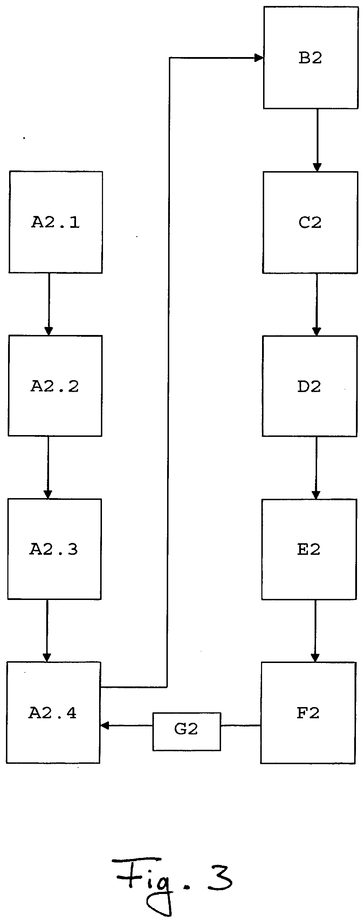

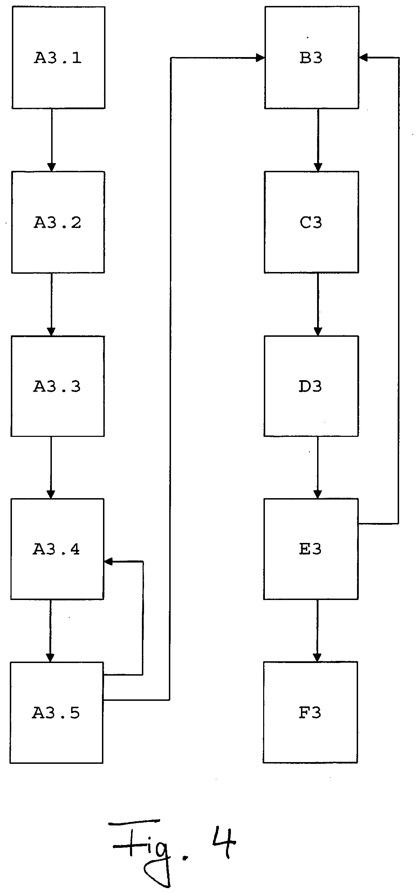

Die Fig. 2, 3 und 4 zeigen schließlich noch Ablaufdiagramme für drei Varianten des erfindungsgemäßen Verfahrens, die angesichts der vorstehenden Ausführungen selbsterklärend sind.

## Patentansprüche

1. Verfahren zur Identifizierung der relativen Einbauposition der in einem modularen elektronischen System zur Verwendung kommenden Module,
wobei das System eine Mehrzahl an über ein Feldbussystem linear miteinander gekoppelten elektronischen Modulen, wenigstens ein Netzteil mit einer dem Netzteil zugeordneten Stromquelle und eine zentrale Steuereinheit aufweist, wobei die Module, gegebenenfalls segmentweise, über geeignet miteinander zu verbindende Ein- und Ausgänge der betreffenden Module in Serie an die dem wenigstens einen Netzteil zugeordnete Stromquelle angeschlossenen sind, wobei der Eingang und der Ausgang jedes Moduls über einen Widerstand miteinander verbunden sind und jedes Modul einen Schalter aufweist, mit welchem der Ausgang des betreffenden Moduls mit einem Referenzpotential verbindbar ist, wobei jeder Stromquelle eine Spannungserfassungseinreichung zugeordnet ist, mit welcher die am Ausgang der Stromquelle gegen ein Referenzpotential anliegende Spannung ermittelbar ist, und
wobei die Identifizierung der relativen Einbauposition der Module dadurch erfolgt, dass in einem durch geeignete Programmierung automatisch ausgeführten Verfahren zu jedem Modul des Systems eine Messung durchgeführt wird, bei der die am Ausgang der dem betreffenden Modul vorgeschalteten Stromquelle anliegende Spannung mittels der Spannungserfassungseinrichtung ermittelt wird, wobei während dieser Messung jeweils
- die dem Modul vorgeschaltete Stromquelle aktiviert ist,
- der Ausgang des betreffenden Moduls über den in das Modul integrierten Schalter mit dem Referenzpotential verbunden ist,
**dadurch gekennzeichnet, dass** während dieser Messung
- die Ausgänge der übrigen Module nicht mit dem Referenzpotential verbunden sind,
wodurch sich die relative Einbauposition der Module aus einem Vergleich der dabei ermittelten Spannungen ergibt.

2. Verfahren zur Identifizierung der relativen Einbauposition der in einem modularen elektronischen System zur Verwendung kommenden Module nach Anspruch 1, wobei das System bauartbedingt genau ein Netzteil mit einer dem Netzteil zugeordneten Stromquelle aufweist, umfassend die folgenden, durch geeignete Programmierung automatisch auszuführenden Schritte:
(A1) Ermittlung und/oder Bestimmung der Feldbus-Adressen aller an das Feldbussystem angeschlossenen Module durch die zentrale Steuereinheit, so dass alle an den Feldbus angeschlossenen Module durch die Steuereinheit individuell ansprechbar sind
(B1) Aussenden einer Anweisung an ein an das Feldbussystem angeschlossenes Modul, seinen Ausgang für einen vorgegebenen Zeitraum unter Verwendung des in dem betreffenden Modul verbauten Schalters mit dem Referenzpotential zu verbinden, wobei innerhalb dieses Zeitraums die sich dabei jeweils am Ausgang der Stromquelle gegenüber dem Referenzpotential einstellende Spannung mittels der der Stromquelle zugeordneten Spannungserfassungseinrichtung ermittelt wird, und wobei nach Abschluss des vorgegebenen Zeitraums oder in Reaktion auf eine entsprechende Anweisung der Ausgang des Moduls wieder von dem Referenzpotential getrennt wird
(C1) Wiederholung des Schrittes (B1) für alle weiteren an das Feldbussystem angeschlossenen Module
(D1) Identifizierung der relativen Einbauposition aller über die dem Netzteil zugeordneten Stromquelle mit Strom versorgten Module anhand der in Schritt (B1) ermittelten und den verschiedenen Modulen zugeordneten Spannungen.

3. Verfahren zur Identifizierung der relativen Einbauposition der in einem modularen elektronischen System zur Verwendung kommenden Module nach Anspruch 1,
wobei das System bauartbedingt eine segmentweise Anordnung von Netzteilen mit jeweils dem betreffenden Netzteil zugeordneter Stromquelle und Modulen gestattet,
wobei jedes Segment genau ein Netzteil mit zugeordneter Stromquelle und wenigstens ein Modul aufweist, wobei die einzelnen Segmente derart in Serie miteinander zu verbinden sind, dass der Ausgang des letzten Moduls eines ersten Segments mit einem an dem Netzteil oder der Stromquelle des nachfolgenden Segments vorgesehenen Segmenteingang verbunden ist, und
wobei jedem Netzteil mit zugeordneter Stromquelle eine zweite Spannungserfassungseinrichtung zugeordnet ist, mit welcher die am Segmenteingang gegen ein Referenzpotential anliegende Spannung ermittelbar ist,
umfassend die folgenden, durch geeignete Programmierung automatisch auszuführenden Schritte:
(A2.1) Ermittlung und/oder Bestimmung der Feldbus-Adressen aller an das Feldbussystem angeschlossenen Netzteile mit zugeordneter Stromquelle und Module durch die zentrale Steuereinheit, so dass alle an den Feldbus angeschlossenen Netzteile, Stromquellen und Module durch die Steuereinheit individuell ansprechbar sind
(A2.2) Aussenden einer Anweisung zum Einschalten aller Stromquellen des Systems
(A2.3) Ermittlung der an allen Segmenteingängen anliegenden Spannung mittels der hierfür vorgesehenen Spannungserfassungseinrichtung, wobei durch Ermittlung desjenigen Segmenteingangs, an dem keine Spannung anliegt, das dem betreffenden Segmenteingang zugeordnete Netzteil und die zugehörige Stromquelle als Netzteil bzw. Stromquelle des ersten Segments identifiziert werden
(A2.4) Aussenden einer Anweisung zur Abschaltung aller Stromquellen mit Ausnahme der dem Netzteil des ersten Segments zugeordneten Stromquelle
(B2) Aussenden einer Anweisung an ein an das Feldbussystem angeschlossenes Modul, seinen Ausgang für einen vorgegebenen Zeitraum unter Verwendung des in dem betreffenden Modul verbauten Schalters mit dem Referenzpotential zu verbinden, wobei innerhalb dieses Zeitraums die sich dabei jeweils am Ausgang der Stromquelle des ersten Segments gegenüber dem Referenzpotential einstellende Spannung mittels der hierfür vorgesehenen Spannungserfassungseinrichtung ermittelt wird, und wobei nach Abschluss des vorgegebenen Zeitraums oder in Reaktion auf eine entsprechende Anweisung der Ausgang des Moduls wieder von dem Referenzpotential getrennt wird
(C2) Wiederholung des Schrittes (B2) für alle weiteren an das Feldbussystem angeschlossenen Module
(D2) Identifizierung aller in dem ersten Segment über die dortige Stromquelle mit Strom versorgten Module und ihrer relativen Einbauposition zur Stromquelle des ersten Segments anhand der in Schritt (B2) ermittelten und den verschiedenen Modulen zugeordneten Spannungen
(E2) Aussenden einer Anweisung zum Einschalten aller Stromquellen des Systems mit Ausnahme derjenigen Stromquellen, die ein Segment des Systems mit Strom versorgen, zu welchem bereits gemäß Schritt (D2) eine Identifizierung aller in dem betreffenden Segment angeordneten Module durchgeführt wurde
(F2) Ermittlung der an allen noch nicht einem bestimmten Segment zugeordneten Segmenteingängen anliegenden Spannung, wobei entweder dasjenige Netzteil bzw. diejenige Stromquelle, an deren Segmenteingang keine Spannung anliegt, als Netzteil bzw. Stromquelle des auf das vorherige Segment folgenden Segments identifiziert wird oder, falls kein solches Netzteil bzw. keine solche Stromquelle mehr existiert, das Verfahren beendet wird
(G2) Wiederholung der Schritte (A2.4) - (F2), wobei in diesen Verfahrensschritten an die Stelle der Stromquelle des ersten Segments diejenige Stromquelle tritt, die gemäß Schritt (F2) als Stromquelle des auf das vorherige Segment folgenden Segments identifiziert wurde, bis alle je ein Netzteil mit zugeordneter Stromquelle aufweisenden Segmente und die daran jeweils angeschlossenen Module erfasst wurden.

4. Verfahren zur Identifizierung der relativen Einbauposition der in einem modularen elektronischen System zur Verwendung kommenden Module nach Anspruch 1,
wobei das System bauartbedingt eine segmentweise Anordnung von Netzteilen mit jeweils dem betreffenden Netzteil zugeordneter Stromquelle und Modulen gestattet,
wobei jedes Segment genau ein Netzteil mit zugeordneter Stromquelle und wenigstens ein Modul aufweist, wobei die einzelnen Segmente derart in Serie miteinander zu verbinden sind, dass der Ausgang des letzten Moduls eines ersten Segments mit einem an dem Netzteil oder der Stromquelle des nachfolgenden Segments vorgesehenen Segmenteingang verbunden ist, und wobei jeder Segmenteingang über einen Schalter mit einem Referenzpotential verbindbar ist, umfassend die folgenden, durch geeignete Programmierung automatisch auszuführenden Schritte:
(A3.1) Ermittlung und/oder Bestimmung der Feldbus-Adressen aller an das Feldbussystem angeschlossenen Netzteile mit zugeordneter Stromquelle und Module durch die zentrale Steuereinheit, so dass alle an den Feldbus angeschlossenen Netzteile, Stromquellen und Module durch die Steuereinheit individuell ansprechbar sind
(A3.2) Aussenden einer Anweisung zum Einschalten aller Stromquellen des Systems und zum Verbinden aller Segmenteingänge mit dem Referenzpotential
(A3.3) Ermittlung der an allen Ausgängen aller Stromquellen anliegenden Spannung mit der hierfür jeweils vorgesehenen Spannungserfassungseinrichtung, wobei diejenige Stromquelle, an deren Ausgang die Leerlaufspannung der Stromquelle gemessen wird, als Stromquelle des letzten Segments des Systems identifiziert wird, und anschließendes Aussenden einer Anweisung zum Trennen des Segmenteingangs des letzten Segments von dem Referenzpotential
(A3.4) Ermittlung der an allen Ausgängen der bisher nicht einem bestimmten Segment zugeordneten Stromquellen anliegenden Spannung mit der hierfür jeweils vorgesehenen
Spannungserfassungseinrichtung, wobei diejenige Stromquelle, an deren Ausgang die Leerlaufspannung der Stromquelle gemessen wird, als Stromquelle des letzten Segments des verbleibenden System identifiziert wird und anschließendes Aussenden einer Anweisung zum Trennen des Segmenteingangs des vorgenannten Segments von dem Referenzpotential
(A3.5) Wiederholen des Schrittes (A3.4) bis die Reihenfolge der den einzelnen Segmenten des Systems zugeordneten Stromquellen und der zugehörigen Netzteile feststeht
(B3) Aussenden einer Anweisung an ein an das Feldbussystem angeschlossenes Modul, seinen Ausgang für eine gewisse Zeit unter Verwendung des hierfür vorgesehenen Schalters mit dem Referenzpotential zu verbinden, wobei gleichzeitig die sich am Ausgang aller Stromquellen gegenüber dem Referenzpotential einstellenden Spannungen mittels der hierfür jeweils vorgesehenen Spannungserfassungseinrichtung ermittelt werden
(C3) Identifizieren derjenigen Stromquelle, an der sich durch die Schaltvorgänge gemäß Schritt (B3) eine Spannungsänderung ergibt
(D3) Abspeichern eines Datensatzes, welcher die Identität des in Schritt (B2) adressierten Moduls, die Identität der in Schritt (C3) identifizierten Stromquelle und den Wert der am Ausgang der vorgenannten Stromquelle gegen das Referenzpotential gemessenen Spannung enthält, die sich in demjenigen Zeitraum ergab, in dem der Ausgang des betreffenden Moduls über den Schalter mit dem Referenzpotential verbunden war
(E3) Wiederholen der Schritte (B3) bis (D3) für alle an das Feldbussystem angeschlossenen Module, so dass in den abgespeicherten Datensätzen jedem Modul eine spezifische Stromquelle und eine spezifische Spannung zugeordnet sind
(F3) Auswertung der abgespeicherten Datensätze zur Identifizierung der relativen Einbauposition aller Netzteile mit zugeordneten Stromquellen und aller Module

5. Verfahren nach einem der Ansprüche 1 bis 4,
**dadurch gekennzeichnet, dass** die
Referenzpotentiale alle durch ein Erdpotential, insbesondere das Erdpotential des Feldbusses gebildet sind.

6. Verfahren nach einem der Ansprüche 1 - 5,
**dadurch gekennzeichnet,**
**dass** die dem jeweiligen Netzteil zugeordnete Stromquelle in das Netzteil integriert ist.

7. Verfahren nach einem der Ansprüche 1- 6,
**dadurch gekennzeichnet,**
**dass** das Feldbussystem ein CAN-Bus ist.

8. Verfahren nach Anspruch 7,
**dadurch gekennzeichnet,**
**dass** Schritt (A.1) bzw. Schritt (A2.1) bzw. Schritt (A3.1) gemäß dem für den CAN-Bus entwickelten FastScan-Algorithmus ausgeführt wird.

9. Verfahren nach einem der vorangehenden Ansprüche,
**dadurch gekennzeichnet,**
**dass** jedes Modul einen Grundkörper und einen hiermit lösbar verbindbaren Aufsatzkörper aufweist, wobei sämtliche Komponenten zur Verbindung der Module über das Feldbussystem und zur Herstellung der Verbindung der Module inklusive des Widerstands zwischen Eingang und Ausgang der jeweiligen Module grundkörperseitig angeordnet sind und wobei die Steuerelektronik jedes Moduls aufsatzkörperseitig angeordnet ist.

10. Modulares elektronisches System umfassend eine Mehrzahl an über ein Feldbussystem linear miteinander gekoppelten elektronischen Modulen, wenigstens ein Netzteil mit einer dem Netzteil zugeordneten Stromquelle und eine zentrale Steuereinheit, wobei die Module, gegebenenfalls segmentweise, über geeignet miteinander zu verbindende Ein- und Ausgänge der betreffenden Module in Serie an die wenigstens eine Stromquelle angeschlossenen sind,
wobei der Eingang und der Ausgang jedes Moduls über einen Widerstand miteinander verbunden sind und jedes Modul einen Schalter aufweist, mit welchem der Ausgang des betreffenden Moduls mit einem Referenzpotential verbindbar ist,
wobei jeder Stromquelle eine Spannungserfassungseinreichung zugeordnet ist, mit welcher die am Ausgang der Stromquelle gegen ein Referenzpotential anliegende Spannung ermittelbar ist,
**dadurch gekennzeichnet, dass**
das System zum Zwecke der Identifizierung der relativen Einbauposition der verschiedenen Module zur Durchführung eines Verfahrens nach einem der vorangehenden Ansprüche eingerichtet ist.

## Claims

1. A method to identify the relative installation position of the modules used in an electronic system,
whereby the system has a plurality of electronic modules that are linearly coupled to each other via a field bus system, at least one power supply unit with a power source that is assigned to the power supply unit and a central control unit, whereby the modules, segment by segment where applicable, are connected in series to the power source that is assigned to at least one power supply unit via input and outputs of the modules concerned that are appropriately connected to each other, whereby the input and the output of each module are connected to each other via a resistor and each module has a switch, with which the output of the module concerned can be connected to a reference potential, whereby a voltage recording device is assigned to each power source, with which the voltage at the output of the power source can be determined in relation to a reference potential and
whereby the identification of the relevant installation position of the modules takes place by carrying out a measurement on each module of the system within the scope of a method that is executed automatically by means of appropriate programming, where the voltage present at the output of the power source that is pre-connected to the module concerned can be detected using the voltage recording device,
whereby, during this measurement, in each case,
- the power source that is pre-connected to the module has been activated,
- the output of the module concerned is connected to the reference potential via the switch integrated into the switch,
**characterized in that** during this measurement
- the outputs of the remaining modules are not connected to the reference potential, from which the relative installation position of the modules results from the comparison of the voltages thereby determined.

2. The method to identify the relative installation position of the modules used in an electronic modular system according to Claim 1, wherein due to its construction, the system has exactly one power supply unit with a power source assigned to the power supply unit, comprising the following steps to be automatically carried out by means of appropriate programming:
(A1) Detection and / or determination of the field bus addresses of all modules connected to the field bus system by the central control unit so that all the modules connected to the field bus can be addressed by the control unit individually
(B1) Sending a command to a module connected to the field bus system to connect its output to the reference potential for a pre-defined period of time using the switch installed into the module concerned, whereby within this period of time, the voltage to be respectively set at the output of the power source in relation to the reference potential is determined using the voltage recording device assigned to the power source, and whereby the output of the module is separated again from the reference potential after the pre-defined period has ended or in response to a related command
(C1) Repeating step (BI) for all other modules connected to the field bus system
(D1) Identification of the relative installation position of all modules supplied with power via the power source assigned to the power supply unit using the voltages determined in step (BI) and assigned to the various modules.

3. The method to identify the relative installation position of the modules used in an electronic modular system according to claim 1,
wherein, due to its construction, the system allows a segmental arrangement of power supply units with a power supply respectively assigned to the power supply unit concerned and modules,
whereby each segment has exactly one power supply unit with an assigned power source and at least one module, whereby the individual segments are to be connected to each other in series in such a way that the output of the last module of a first segment is connected to a segment input provided at the power supply unit or the power source of the subsequent segment and
whereby a second voltage recording device is assigned to each power supply unit with an assigned power source, with which the voltage at the segment input can be determined against a reference potential, comprising the following steps that are to be automatically executed by means of appropriate programming:
(A2.1) Detection and / or determination by the central control unit of the field bus addresses of all power supply units connected to the field bus system with an assigned power source and modules so that all the power supply units, power sources and modules connected to the field bus can be addressed by the control unit individually
(A2.2) Sending a command to switch on all the system's power sources
(A2.3) Determination of voltage at all segment inputs using the voltage recording device provided for this purpose, whereby, by means of determining that segment input where no voltage is present, the power supply unit assigned to the segment input concerned and the power source belong to it can be identified as a power supply unit or a power source of the first segment
(A2.4) Sending a command to switch off all power sources except the power source assigned to the power supply unit of the first segment
(B2) Sending a command to a module connected to the field bus system to connect its output to the reference potential for a pre-defined period of time using the switch installed into the module concerned, whereby within this period of time, the voltage to be respectively set at the output of the power source of the first segment in relation to the reference potential is determined using the voltage recording device provided for this purpose, and whereby the output of the module is separated again from the reference potential after the pre-defined period has ended or in response to a related command
(C2) Repeating step (B2) for all other modules connected to the field bus system
(D2) Identification of all the modules in the first segment supplied with power via the power source there and their relative installation position to the power source of the first segment there using the voltages determined in step (B2) and assigned to the various modules
(E2) Sending out a command to switch on all the system's power sources except those power sources that supply a segment of the system with power, for which an identification of all the modules arranged in the segment concerned has been carried out in accordance with step (D2)
(F2) Determination of voltage at all segment inputs not yet assigned to a certain segment, whereby either that power support supply unit or that power source where there is no voltage at their segment input is identified as a power supply unit or a power source of the segment that follows the previous segment or if no such power supply unit or no such power source no longer exists, the method is ended
(G2) Repetition of steps (A2.4) - (F2), whereby within the scope of this method, in place of the power source of the first segment, that power source comes to play that has been identified as a power source of the segment that follows the previous segment in accordance with step (F2) until all segments each having a power supply unit with an assigned power source and the modules respectively connected to it have been registered.

4. The method to identify the relative installation position of the modules used in an electronic modular system according to claim 1,
wherein, due to its construction, the system allows a segmental arrangement of power supply units with a power source respectively assigned to the power supply unit concerned and modules,
whereby each segment has exactly one power supply unit with an assigned power source and at least one module, whereby the individual segments are to be connected to each other in series in such a way that the output of the last module of a first segment is connected to a segment input provided on the power supply unit or the power source of the subsequent segment and
whereby each segment input can be connected to a reference potential via a switch, comprising the following steps to be executed automatically by means of appropriate programming:
(A3.1) Detection and/or determination by the central control unit of the field bus addresses of all power supply units connected to the field bus system with an assigned power source and modules so that all the power supply units, power sources and modules connected to the field bus can be addressed by the control unit individually
(A3.2) Sending a command to switch on all the system's power sources and to connect all segment inputs to the reference potential
(A3.3) Determination of the voltage at all outputs of all power sources with the voltage recording device respectively provided for this purpose, whereby that power source, at the output of which the open-circuit voltage of the power source is measured is identified as a power source of the system's last segment, along with sending out a command to separate the segment input of the last segment from the reference potential
(A3.4) Determination of the voltage at all outputs of power sources not yet assigned to a certain segment with the voltage recording device respectively provided for this purpose, whereby that power source, at the output of which the open-circuit voltage of the power source is measured is identified as a power source of the remaining system's last segment, along with sending out a command to separate the segment input of the previously specified segment from the reference potential
(A3.5) Repetition of step (A3.4) until the sequence of the power sources assigned to the system's individual segments and the corresponding powers supply units have been defined
(B3) Sending a command to a module connected to the field bus system to connect its output to the reference potential for a certain period of time using the switch provided for this purpose, whereby, at the same time, within this period of time, the voltages to be respectively set at the output of the power source in relation to the reference potential are determined using the voltage recording device respectively provided for this purpose
(C3) Identification of that power source where the switching operations result in a change in voltage in accordance with step (B3)
(D3) Saving a data set that contains the identity of the module addressed in step (B2), the identity of the power source identified in step (C3) and the level of the voltage measured at the output of the previously mentioned power source with relation to the reference potential that resulted during that period in which the output of the module concerned was connected to the reference potential via the switch
(E3) Repetition of steps (B3) to (D3) for all modules connected to the field bus system so that a specific power source and a specific voltage are assigned to each module in the saved data sets
(F3) Evaluation of the saved data sets to identify the relative installation position of all power supply units with assigned power sources and all modules

5. The method according to one of the claims 1 to 4, **characterized in that** the reference potentials are all formed by an earthing potential, more preferably the earthing potential of the field bus.

6. The method according to one of the claims 1 - 5, **characterized in that** the power source assigned to the respective power supply unit has been integrated into the power supply unit

7. The method according to one of the claims 1 - 6, **characterized in that** the field bus system is a CAN bus.

8. The method according to claim 7, **characterized in that** step (A.1) and step (A2.1) and step (A3.1) is carried out in accordance with the FastScan algorithm developed for the CAN bus.

9. The method according to one of the preceding claims, **characterized in that** each module has a base body and an attachment body, whereby all components are positioned on the base body to connect the modules over the field bus system and to establish the connection of the modules including the resistor between the input and output of the respective modules and whereby the control electrons of each module is positioned on the attachment body.

10. A modular electronic system comprising a plurality of electronic modules linearly coupled to each other via a field bus system, at least one power supply unit with a power source assigned to the power supply unit and a central control unit, whereby the modules, segment by segment where applicable, are connected in series to the at least one power source via inputs and outputs of the modules concerned that are to be appropriately connected to one another,
whereby the input and the output of each module are connected to each other via a resistor and each module has a switch, with which the output of the module concerned can be connected to a reference potential, whereby a voltage recording device is assigned to each power source, which the voltage at the output of the power source can be determined with relation to a reference potential,
**characterized in that**
the system has been set up for the purpose of identifying the relative installation position of the various modules to carry out a method according to one of the preceding claims.

## Revendications

1. Procédé d'identification de la position relative de montage des modules en utilisation dans un système modulaire électronique,
le système comportant une pluralité de modules électroniques couplés linéairement les uns aux autres par un système de bus de terrain, au moins une partie du réseau avec une source de courant affectée à la partie de réseau et une unité centrale de commande,
les modules étant connectés en série à au moins une source de courant affectée à au moins une partie de réseau, le cas échéant par segment, par le biais d'entrées et de sorties des modules concernés à relier entre eux de façon appropriée, l'entrée et la sortie de chaque module étant reliées entre elles par une résistance et chaque module comportant un commutateur avec lequel la sortie du module concerné peut être reliée à un potentiel de référence, un dispositif de la saisie de la tension étant affecté à chaque source de courant avec laquelle la tension présente à la sortie de la source de courant par rapport à un potentiel de référence peut être déterminée et
l'identification de la position relative de montage des modules ayant lieu par le fait que dans un procédé exécuté automatiquement par programmation appropriée pour chaque module du système une mesure est effectuée, pour laquelle la tension présente à la sortie de la source de courant connectée en amont du module concerné est déterminée au moyen du dispositif de saisie de la tension, pendant cette mesure
- la source de courant connectée en amont du module étant respectivement activée,
- la sortie du module concerné étant reliée par le commutateur intégré au module au potentiel de référence
**caractérisé en ce que** pendant cette mesure,
- les sorties des autres modules ne sont pas reliées au potentiel de référence,
la position relative de montage des modules étant de ce fait obtenue à partir d'une comparaison des tensions déterminées à cet effet.

2. Procédé d'identification de la position relative de montage des modules en utilisation dans un système modulaire électronique selon la revendication 1, le système comportant de par son type de construction exactement une partie du réseau avec une source de courant affectée à la partie de réseau, comprenant les étapes suivantes à exécuter automatiquement par programmation appropriée :
(A1) détermination et/ou définition des adresses de bus de terrain de tous les modules connectés au système de bus de terrain par l'unité centrale de commande de telle manière que tous les modules connectés au bus de terrain peuvent être individuellement sollicités par l'unité de commande,
(B1) envoi d'une instruction à un module connecté au système de bus de terrain de relier sa sortie pour une période prédéterminée en utilisant le commutateur monté dans le module concerné au potentiel de référence, pendant cette période de temps la tension s'établissant respectivement à cet effet à la sortie de la source de courant par rapport au potentiel de référence étant déterminée au moyen du dispositif de saisie de la tension affecté à la source de courant et une fois la période de temps prédéterminée écoulée ou en réaction à une instruction prédéterminée, la sortie du module étant à nouveau séparée du potentiel de référence,
(C1) répétition de l'étape (B1) pour tous les autres modules connectés au système de bus de terrain,
(D1) identification de la position relative de montage de tous les modules alimentés en courant par la source de courant affectée à la partie de réseau à l'aide des tensions déterminées à l'étape (B1) et affectées aux différents modules.

3. Procédé d'identification de la position relative de montage des modules en utilisation dans un système modulaire électronique selon la revendication 1,
le système permettant de par son type de construction une disposition segmentée des parties de réseau avec la source de courant et les modules respectivement affectés à la partie de réseau concernée,
chaque segment comportant exactement une partie de réseau avec une source de courant affectée et au moins un module, les segments individuels devant être reliés entre eux en série de telle manière que la sortie du dernier module d'un premier segment est reliée à une entrée de segment prévue sur la partie de réseau ou la source de courant du segment suivant, et
un deuxième dispositif de saisie de la tension étant affecté à chaque partie de réseau avec une source de courant affectée avec lequel la tension présente à l'entrée du segment peut être déterminée par rapport à un potentiel de référence,
comprenant les étapes suivantes à exécuter automatiquement par programmation appropriée :
(A2.1) détermination et/ou définition des adresses de bus de terrain de toutes les parties de réseau connectées au système de bus de terrain par l'unité centrale de commande de telle manière que toutes les parties de réseau, sources de courant et tous les modules connectés au bus de terrain peuvent être individuellement sollicités par l'unité de commande,
(A2.2) envoi d'une instruction pour mettre en marche toutes les sources de courant du système,
(A2.3) détermination de la tension présente à toutes les entrées de segment au moyen du dispositif de saisie de la tension prévu à cet effet, en déterminant l'entrée de segment à laquelle il n'y a aucune tension, la partie de réseau affectée à l'entrée de segment concernée et la source de courant correspondante étant identifiées en tant que partie de réseau ou source de courant du premier segment,
(A2.4) envoi d'une instruction pour mettre à l'arrêt toutes les sources de courant à l'exception de la source de courant affecté à la partie de réseau du premier segment,
(B2) envoi d'une instruction à un module connecté au système de bus de terrain de relier sa sortie pour une période de temps prédéterminée en utilisant le commutateur monté dans le module concerné au potentiel de référence, pendant cette période de temps la tension s'établissant à cet effet respectivement à la sortie de la source de courant du premier segment étant déterminée par rapport au potentiel de référence au moyen du système de saisie de la tension prévu à cet effet et une fois la période de temps prédéterminée écoulée ou en réaction à une instruction correspondante, la sortie du module étant à nouveau séparée du potentiel de référence,
(C2) répétition de l'étape (B2) pour tous les autres modules connectés au système de bus de terrain,
(D2) identification de tous les modules alimentés en courant dans le premier segment par la source de courant locale et de leur position relative de montage par rapport à la source de courant du premier segment à l'aide des tensions déterminées à l'étape (B2) et affectée aux différents modules,
(E2) envoi d'une instruction pour mettre en marche toutes les sources de courant du système à l'exception des sources de courant qui alimentent en courant un segment du système pour lequel une identification de tous les modules disposés dans le segment concerné a déjà été effectuée dans l'étape (D2),
(F2) détermination de la tension présente sur toutes les entrées non encore affectées à un segment défini, soit la partie de réseau ou la source de courant à l'entrée de segment desquelles il n'y a pas de tension étant identifiée comme partie de réseau ou source de courant du segment suivant le segment précédent, soit, si aucune partie de réseau ou source de courant de ce type n'existe plus, le procédé étant terminé,
(G2) répétition des étapes (A2.4) - (F2), dans ces étapes de procédé à l'emplacement de la source de courant du premier segment où arrive la source de courant qui a été identifiée comme source de courant du segment suivant le segment précédent selon l'étape (F2) jusqu'à ce que tous les segments comportant respectivement une partie de réseau avec une source de courant affectée et les modules respectivement connectés à ceux-ci aient été saisis.

4. Procédé d'identification de la position relative de montage des modules en utilisation dans un système modulaire électronique selon la revendication 1,
le système permettant de par son type de construction une disposition par segment des parties de réseau avec respectivement une source de courant et des modules affectés respectivement à la partie de réseau concernée
chaque segment comportant exactement une partie de réseau avec une source de courant affectée et au moins un module, les segments individuels étant à relier entre eux en série de telle manière que la sortie du dernier module d'un premier segment est reliée avec une entrée de segment prévue sur la partie de réseau ou la source de courant du segment suivant, et
chaque entrée de segment pouvant être reliée par un commutateur à un potentiel de référence,
comprenant les étapes suivantes à exécuter automatiquement par programmation appropriée :
(A3.1) détermination et/ou définition des adresses de bus de terrain de toutes les parties de réseau connectées au système de bus de terrain par l'unité centrale de commande de telle manière que toutes les parties de réseau, sources de courant et tous les modules connectés au bus de terrain peuvent être individuellement sollicités par l'unité de commande,
(A3.2) envoi d'une instruction pour la mise en marche de toutes les sources de courant du système et pour relier toutes les entrées de segment au potentiel de référence,
(A3.3) détermination de la tension présente à toutes le sorties de toutes les sources de courant avec le dispositif de saisie de la tension respectivement prévu à cet effet, la source de courant à la sortie de laquelle la tension à vide de la source de courant a été mesurée, étant identifiée comme source de courant du dernier segment du système et envoi ultérieur d'une instruction pour séparer l'entrée de segment du dernier segment du potentiel de référence,
(A3.4) détermination de la tension présente à toutes les sorties des sources de courant jusqu'ici non affectées à un segment défini avec le dispositif de saisie de la tension prévu respectivement à cet effet, la source de courant à la sortie de laquelle la tension à vide de la source de courant a été mesurée, étant identifiée comme source de courant du dernier segment du système restant et envoi ultérieur d'une instruction pour séparer de l'entrée de segment du segment précité du potentiel de référence,
(A3.5) répétition de l'étape (A3.4) jusqu'à ce que la succession des sources de courant affectées aux segments individuels du système et des parties de réseau correspondantes soit établie,
(B3) envoi d'une instruction à un module connecté au système de bus de terrain de relier sa sortie pour un certain temps en utilisant le commutateur prévu à cet effet au potentiel de référence, les tensions s'établissant simultanément à la sortie de toutes les sources de courant par rapport au potentiel de référence étant déterminées au moyen du dispositif de saisie de la tension prévu à cet effet
(C3) identification de la source de courant sur laquelle on obtient une variation de tension par les opérations de commutation selon l'étape (B3) ,
(D3) mémorisation d'un jeu de données, lequel contient l'identité du module adressé dans l'étape (B2), l'identité de la source de courant identifiée dans l'étape (C3) et la valeur de la tension mesurée à la sortie de la source de courant précitée par rapport au potentiel de référence, que l'on a obtenue au cours de la période de temps au cours de laquelle la sortie du module concerné a été reliée par le commutateur au potentiel de référence,
(E3) répétition des étapes (B3) à (D3) pour tous les modules connectés au système de bus de terrain de telle sorte que dans les jeux de données mémorisés une source de courant spécifique et une tension spécifique sont affectées à chaque module,
(F3) exploitation des jeux de données mémorisés pour identifier la position relative de montage de toutes les parties de réseau avec les sources de courant affectées et de tous les modules.

5. Procédé selon l'une quelconque des revendications 1 à 4, **caractérisé en ce que** les potentiels de référence sont tous formés par un potentiel terrestre, notamment un potentiel terrestre du bus de terrain.

6. Procédé selon l'une quelconque des revendications 1 - 5, **caractérisé en ce que** la source de courant affectée à la partie de réseau respective est intégrée dans la partie de réseau.

7. Procédé selon l'une quelconque des revendications 1 - 6, **caractérisé en ce que** le système de bus de terrain est un bus CAN.

8. Procédé selon la revendication 7, **caractérisé en ce que** l'étape (A.1) ou l'étape (A2.1) ou l'étape (A3.1) est exécutée selon l'algorithme FastScan mis au point pour le bus CAN.

9. Procédé selon l'une quelconque des revendications précédentes, **caractérisé en ce que** chaque module comporte un corps de base et un corps rapporté pouvant être relié à celui-ci de façon amovible, tous les composants pour la liaison des modules par le système de bus de terrain et pour réaliser la liaison des modules y compris de la résistance entre l'entrée et la sortie des modules respectifs étant disposés du côté du corps de base et le système électronique de commande de chaque module étant disposé du côté du corps rapporté.

10. Système modulaire électronique comprenant une pluralité de modules électroniques couplés entre eux de façon linéaire par un système de bus de terrain, au moins une partie de réseau avec une source de courant affectée à une partie de réseau et une unité centrale de commande, les modules étant connectés le cas échéant par segment en série à au moins une source de courant par les entrées et sorties des modules concernés à relier entre eux de façon appropriée,
l'entrée et la sortie de chaque module étant reliées entre elles par une résistance et chaque module comportant un commutateur avec lequel la sortie du module concerné peut être reliée à un potentiel de référence,
un dispositif de saisie de la tension étant affecté à chaque source de courant avec lequel la tension présente à la sortie de la source de courant peut être déterminée par rapport à un potentiel de référence,
**caractérisé en ce que**
le système est agencé pour exécuter un procédé selon l'une quelconque des revendications précédentes dans le but d'identifier la position relative de montage des différents modules.
